# FASCICULE DE BREVET EUROPEEN

(11) **EP 3 311 335 B1**
(45) Date de publication et mention de la délivrance du brevet: **27.02.2019**
(21) Numéro de dépôt: 16731085.3
(22) Date de dépôt: 15.06.2016
(51) Int. Cl.: G06K 19/00, H05K 3/12, H05K 3/28

(54) **PROCÉDÉ DE TRAITEMENT DE SURFACE D'UNE CARTE ÉLECTRONIQUE À L'AIDE D'UNE TORCHE À PLASMA ET DISPOSITIF CORRESPONDANT**
VERFAHREN ZUR BEHANDLUNG DER OBERFLÄCHE EINER ELEKTRONISCHEN KARTE MITTELS EINES PLASMABRENNERS UND VORRICHTUNG DAFÜR
METHOD FOR TREATING THE SURFACE OF AN ELECTRONIC CARD WITH A PLASMA TORCH AND DEVICE THEREFOR

(30) Priorité: 19.06.2015 FR 1555632
(43) Date de publication de la demande: 25.04.2018
(73) Titulaire: Exelsius, 06370 Mouans Sartoux (FR)
(72) Inventeur: LANTERI, Alain, 06510 Carros (FR); SUBILEAU, Ronan, 06370 Mouans Sartoux (FR); FERRARI, Francis, 06650 Le Rouret (FR); SARRAZY, Mathieu, 06130 Grasse (FR)
(74) Mandataire: Lavialle, Bruno François Stéphane
(86) Numéro de dépôt international: PCT/EP2016/063710
(87) Numéro de publication internationale: WO 2016/202836

(56) Documents cités:
- WO-A1-2015/020760
- FR-A1- 2 854 256
- US-A1- 2003 087 530
- US-A1- 2008 197 533

## Description

L'invention concerne essentiellement le domaine des procédés de traitement de surfaces d'une carte électronique, afin notamment d'obtenir une tension de surface minimale de ces surfaces ainsi traitées. L'invention concerne également le domaine des dispositifs de traitement de surfaces d'une carte électronique pour obtenir une tension de surface minimale de surfaces ainsi traitées à l'aide du dispositif.

### ARRIERE PLAN DE L'INVENTION

Il est d'usage d'appliquer sur des surfaces de cartes électroniques une couche protectrice, par exemple un vernis de protection de la carte, ou un liant électrique, mécanique ou thermique. Certaines au moins de ces surfaces des cartes pouvant être en matériaux polymères.

Afin de favoriser l'adhérence de la couche / vernis, liant, il est souhaitable que l'application soit réalisée sur une surface de carte présentant une mouillabilité minimale, c'est-à-dire présentant une tension de surface minimale prédéterminée.

Pour adapter la tension de surface, on peut traiter la carte par projection, sur la / les surface(s) à traiter de la carte, d'un plasma généré à l'aide d'une torche à plasma.

Le brevet US3,309,299 décrit l'usage de plasma à décharge pour traiter et augmenter la mouillabilité de polymères tels que des polymères de carte électronique.

La demande de brevet US 2008/0197533 A1 décrit un procédé de fabrication de cartes de paiement électroniques à l'aide d'un plasma d'air pour modifier les surfaces plastiques de ces cartes.

On a constaté qu'il est difficile d'obtenir une tension de surface minimale requise sur toutes les surfaces traitées de la carte et cela peut conduire à des défauts d'adhérence de la couche protectrice ou du liant, ce qui peut provoquer une dégradation de qualité de la carte ainsi obtenue.

### OBJET DE L'INVENTION

Un objet de la présente invention est de permettre une amélioration de la qualité de traitement de surfaces de la carte électronique par projection de flux plasma.

### RESUME DE L'INVENTION

A cette fin, selon un premier aspect de l'invention, il est proposé un procédé de traitement de surfaces d'une carte électronique à l'aide d'une torche à plasma générant un flux de plasma, cette carte comportant plusieurs composants électroniques, la carte présentant plusieurs surfaces à traiter disposées à différentes hauteurs par rapport à un plan de référence de la carte électronique, certaines au moins de ces surfaces à traiter étant formées sur certains au moins des composants de la carte électronique. Le procédé selon l'invention est essentiellement, caractérisé en ce que :
- on détermine au moins une zone à traiter de la carte électronique, cette zone à traiter contenant lesdites surfaces à traiter ;
- on détermine une plage de travail idéale propre à la torche à plasma, cette plage de travail étant localisée par rapport à un point donné de cette torche; et
- à l'aide d'un algorithme exécuté par un calculateur, on détermine des strates parallèles audit plan de référence de la carte, chacune de ces strates contenant au moins une des surfaces à traiter qui lui correspond, puis on génère une trajectoire de déplacement de ladite torche telle que lorsque cette trajectoire de déplacement est exécutée :
   - les surfaces à traiter soient traitées en suivant un ordre chronologique, consistant à traiter toutes les surfaces à traiter contenues dans une strate donnée avant de commencer à traiter les surfaces à traiter contenues dans une autre des strates données ; et telle que
   - pour chaque strate donnée, on traite les surfaces à traiter contenues dans cette strate donnée en déplaçant la torche de manière que ledit point donné de cette torche suive exclusivement une trajectoire planaire parallèle au plan de référence de la carte électronique ; et telle que
   - à tout moment donné lors de la projection du flux plasma sur une des surfaces à traiter, on ait une partie courante de surface à traiter recevant ce flux plasma à ce moment donné qui est exclusivement placée dans la plage de travail idéale prédéterminée.

Chaque strate est un volume virtuel formé entre des premier et second plans limites de la strate qui sont parallèles entre eux et aussi parallèles au plan de référence de la carte. La distance entre des premier et second plans limites d'une même strate définissent l'épaisseur de cette strate.

Chaque strate est déterminée de manière à contenir au moins une des surfaces à traiter, en d'autres termes, les différentes surfaces à traiter sont réparties entre les différentes strates qui ont été déterminées. Ainsi, sachant que plusieurs surfaces à traiter peuvent être contenues dans une même strate, il y a au moins autant de surfaces à traiter que de strates.

Le point donné de la torche est un point de référence de la torche servant d'origine à un repère de la torche pour pouvoir positionner la torche par rapport à la surface de travail à traiter qui est en cours de traitement tout en s'assurant que cette surface en cours de traitement se trouve placée dans la plage de travail idéale propre à la torche. Typiquement, le point donné de la torche peut être un point d'extrémité de la buse de la torche ou tout autre point localisable de la torche.

Le procédé selon l'invention permet d'analyser la zone à traiter de la carte et d'identifier dans cette zone les emplacements des différentes surfaces à traiter.

Les surfaces à traitées ainsi identifiées sont réparties dans des strates virtuelles ce qui permet de regrouper les surfaces à traiter strate par strate.

Cette répartition facilite le calcul de la trajectoire de déplacement de la torche qui doit traiter toutes les surfaces à traiter se trouvant dans une strate donnée avant de passer à aux surfaces se trouvant dans une autres des strates.

Comme le traitement des surfaces à traiter d'une même strate est réalisé en déplaçant la torche exclusivement le long d'une trajectoire exclusivement planaire, on limite les défauts de positionnement de la torche vis-à-vis des différentes surfaces à traiter appartenant à cette torche. Il en résulte une amélioration de l'homogénéité de traitement des surfaces à traiter appartenant à une même strate donnée.

Au global, quelle que soit la strate concernée, toutes les surfaces à traiter de la zone à traiter de la carte sont traitées alors qu'elles se trouvent exclusivement placées dans la plage de travail idéale prédéterminée, il en résulte une homogénéisation du traitement entre les surfaces appartenant à des strates différentes.

Cette homogénéisation de la qualité du traitement des différentes surfaces traitées de la carte électronique contribue à améliorer la qualité globale du traitement du matériau de la carte traitée qui peut être un matériau polymère.

Ceci facilite grandement l'obtention d'une tension de surface minimale nécessaire et homogène entre les différentes surfaces traitées.

Le procédé selon l'invention est ainsi utile pour améliorer l'adhérence de couche protectrice, ou de liant électrique, mécanique ou thermique sur les surfaces traitées.

Ce procédé permet de traiter tous les types de cartes électroniques qui présentent une pluralité de composants électroniques ayant des surfaces à traiter disposées à différentes hauteurs par rapport à un plan de référence de la carte électronique (certaines des surfaces à traiter peuvent être dans un matériau polymère).

Une carte électronique peut porter des composants électroniques comme un ou plusieurs modules électroniques. Certains de ces modules peuvent eux aussi contenir des cartes électroniques à traiter. La carte traitée peut ainsi appartenir à un module et se trouver dans un boitier du module. La carte traitée peut être partie de produits électroniques semi-finis ou finis.

Selon un mode de réalisation particulier du procédé de l'invention, la plage de travail présente une limite maximale de travail située à une distance maximale Dmax prédéterminée par rapport au point donné de cette torche et une limite minimale de travail située à une distance minimale Dmin prédéterminée par rapport audit point donné de cette torche, ces distances minimale et maximale prédéterminées étant mesurées suivant un axe de travail de la torche passant par ledit point donné de cette torche.

Typiquement la plage de travail choisie s'étend sur moins de 10 mm. Dans le cas où le point donné de la torche est situé à l'extrémité de la buse, la distance maximale Dmax est de 20mm mesurés selon l'axe de travail de la torche (l'axe de travail est l'axe principal du flux de plasma projeté par la torche) et la distance minimale Dmin est par conséquent égale à la valeur Dmax de laquelle est soustraite la longueur de plage. Ainsi, Dmin est de 10 mm mesurés selon l'axe de travail, à partir du point donné de la torche.

Selon un second aspect de l'invention, il est aussi proposé un dispositif adapté à mettre en oeuvre le procédé selon l'invention conforme à l'un quelconque des modes de réalisation de ce procédé.

Plus particulièrement, l'invention concerne un dispositif de traitement de surfaces d'une carte électronique, comportant :
- des moyens de support adaptés à supporter une carte électronique comportant plusieurs composants électroniques disposés à différentes hauteurs par rapport à un plan de référence de la carte électronique ;
- une torche à plasma générant un flux de plasma ;
- des moyens de déplacement relatif de la torche vis-à-vis des moyens de support portant une carte électronique ;
- des moyens de mémorisation dans lesquels sont stockés :
   1) des premières données représentatives de la position d'au moins une zone à traiter de la carte électronique, et de positions respectives de surfaces à traiter formées sur certains au moins des composants électroniques et contenues dans cette zone à traiter ;
   2) des secondes données représentatives de la position par rapport à un point donné de cette torche d'une plage de travail idéale propre à cette torche à plasma ; et
   3) un algorithme.

Ce dispositif de traitement de surface comporte en outre un calculateur adapté à exécuter ledit algorithme et, en réponse à l'exécution de cet algorithme, à :
- déterminer des strates parallèles audit plan de référence de la carte, chaque surface à traiter étant contenue dans une de ces strates qui lui correspond ; puis
- à générer une trajectoire de déplacement de ladite torche mise en oeuvre à l'aide des moyens de déplacement et telle que :
   - les surfaces à traiter soient respectivement traitées par projection du flux plasma en suivant un ordre chronologique, consistant à traiter toutes les surfaces à traiter contenues dans une strate donnée avant de commencer à traiter les surfaces à traiter contenues dans une autre des strates données ; et telle que

   - pour chaque strate donnée, on traite les surfaces à traiter contenues dans cette strate donnée en déplaçant la torche de manière que ledit point donné de cette torche suive exclusivement une trajectoire planaire parallèle au plan de référence de la carte électronique ; et telle que
   - à tout moment donné lors de la projection du flux plasma sur une des surfaces à traiter, on ait une partie courante de surface à traiter recevant ce flux plasma à ce moment donné qui est exclusivement placée dans la plage de travail idéale prédéterminée.

Lorsqu'il est mis en oeuvre pour le traitement d'une carte électronique, ce dispositif de l'invention permet d'obtenir les avantages précités du procédé selon l'invention.

### BREVE DESCRIPTION DES DESSINS

L'invention sera mieux comprise à la lecture de la description qui suit de modes de réalisation non limitatifs, en référence aux figures des dessins annexés parmi lesquelles :
La figure 1 illustre une succession d'étapes mises en oeuvre conformément au procédé de l'invention ;
Les figures 2a, 2b 2c, 2d illustrent le dispositif selon l'invention alors qu'il met en oeuvre le procédé de l'invention.

### DESCRIPTION DETAILLEE DE L'INVENTION

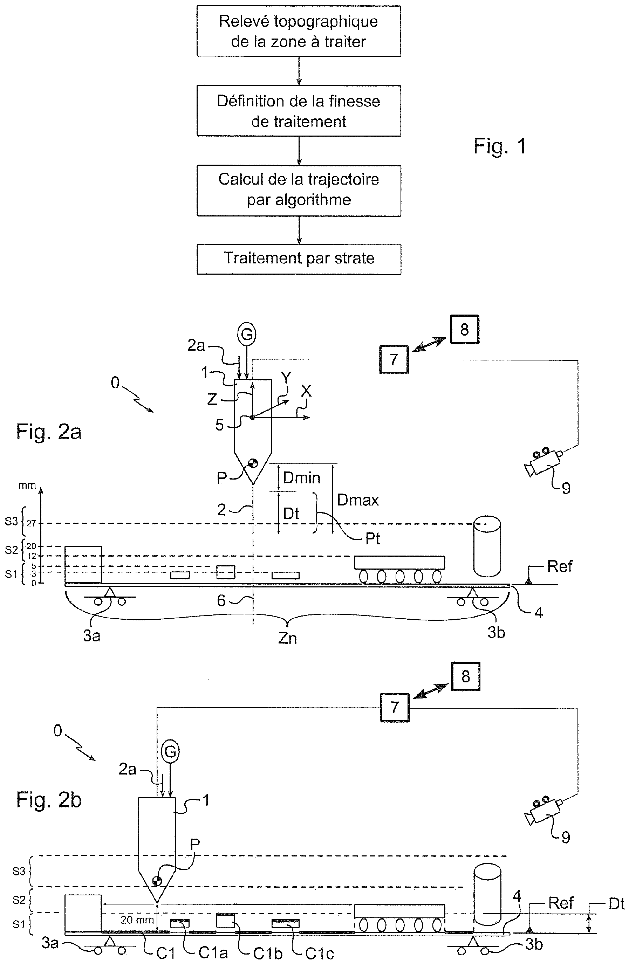

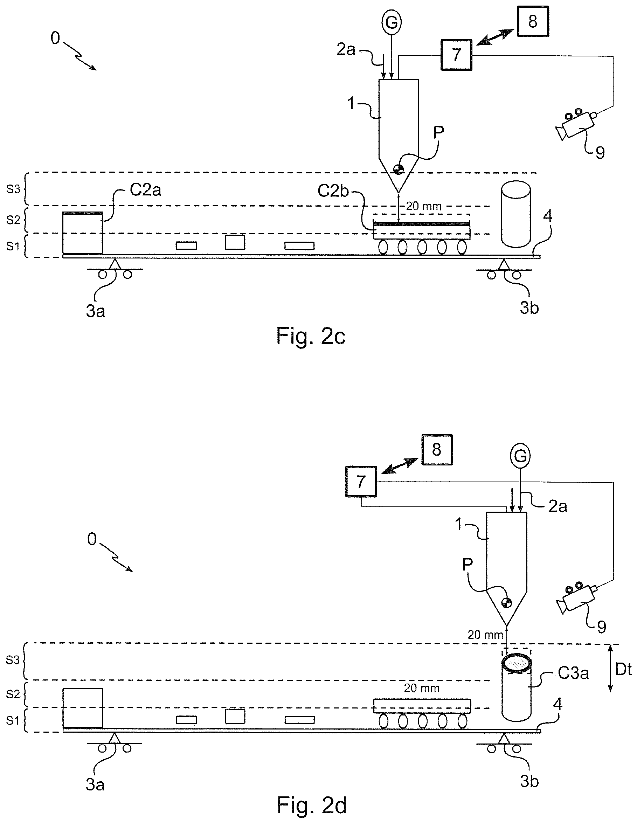

Comme indiqué précédemment, l'invention concerne un procédé de traitement de surfaces appartenant à une carte électronique et étant disposées à différentes hauteurs par rapport à un plan de référence Ref de la carte 4. Les surfaces traitées sont illustrées en trait gras épais sur les figures 2b, 2c, 2d. Certaines des surfaces traitées peuvent être en matériau polymère.

Ce traitement de surfaces est réalisé à l'aide d'une torche à plasma 1 générant un flux de plasma 2, de type plasma soufflé aussi appelé plasma atmosphérique.

Un type de torche à plasma 1 pouvant être utilisé pour mettre en oeuvre ce procédé est par exemple présenté par le document brevet US3,309,299.

Comme on le voit en particulier sur les figures 2a, 2b, 2c, 2d, le dispositif 0 selon l'invention comporte une torche à plasma atmosphérique 1 alimentée en gaz, par exemple de l'air ou de l'azote ou autre, via une conduite 2a et en électricité via une source d'alimentation G.

L'alimentation G est reliée à des électrodes, non représentées, de la torche 1 pour générer un champ électrique alternatif entre ces électrodes et ainsi former un plasma entre ces électrodes. Des moyens de régulation d'un débit de gaz (non représentés) sont reliés à la conduite 2a pour contrôler un débit d'air passant entre les électrodes de manière à générer un flux de plasma 2 en sortie d'une buse de la torche 1. Le gaz peut être également purifié avant d'être admis dans la torche via un filtre et une régulation de traitement. Typiquement, on cherche à ce que l'air admis ne présente aucune particule de plus de 0.1 micron, qu'il ait une point de rosée inférieur à +3°C et qu'il ne présente pas plus de 0.012 mg/m³ de résidu d'huile. La pression de ce gaz peut être régulée et sera préférentiellement entre 3 et 5 bars (3 10⁵ - 5 10⁵ Pa). La torche peut être équipée de raccords rapides pneumatique et de connectiques électrique enfichables de manière à faciliter le remplacement de la torche. Le débit de gaz peut être choisi pour être au moins égal à 30 L/mn, préférentiellement entre 40 et 60 L/mn, préférentiellement 50 L/mn.

La régulation du débit de gaz et/ou de la fréquence d'alimentation électrique et/ou de l'intensité de cette alimentation sont régulés pour permettre de réguler les dimensions et la position de la plage de travail idéale par rapport au point donné P de la torche. Cette régulation peut être réalisée via le calculateur décrit ci-après. La section de la plage de travail peut aussi être déterminée en fonction de la section de passage de plasma en sortie de torche.

Le dispositif 0 comprend également des moyens de support 3a, 3b adaptés à supporter une carte électronique 4. Cette carte 4 comporte plusieurs composants électroniques C1a, C1b, C1c, C2a, C2b, C3a qui présentent chacun des surfaces à traitées respectivement disposées à différentes hauteurs par rapport à un plan de référence Ref de la carte électronique 4, ainsi que des zones à traiter type C1, correspondantes à la surface du vernis épargne de la carte électronique et qui s'étendent dans le plan principal de la carte aussi noté plan de référence Ref. Le dispositif de l'invention 0 comprend aussi des moyens 5 de déplacement relatif de la torche 1 vis-à-vis des moyens de support 3a, 3b qui portent la carte électronique 4.

Un exemple de moyens de déplacement 5 peut comporter un premier axe motorisé (non représenté) portant la torche pour la déplacer selon un axe Z perpendiculaire au plan de référence Ref de la carte, un second axe motorisé (non représenté) pour déplacer la torche 1 suivant un axe X parallèle audit plan de référence Ref et un troisième axe motorisé (non représenté) pour déplacer la torche 1 suivant un axe Y parallèle audit plan de référence Ref et perpendiculaire à l'axe X.

Ces trois axes motorisés sont commandés par le calculateur (éventuellement via un automate de régulation) pour permettre le déplacement de la torche selon les trois axes X, Y, Z qui sont orthogonaux entre eux. Les axes motorisés sont tels que quelle que soit la trajectoire de la torche, son axe de travail 6 reste toujours dans la même orientation par rapport au plan de référence Ref. En l'occurrence l'axe de travail 6 de la torche 1 reste perpendiculaire au plan Ref et cela quel que soit la trajectoire de déplacement du point donné P de la torche par rapport à ce plan de référence Ref.

Il est à noter que cet axe de travail 6 est fixe par rapport à la torche et passe par un point donné P de cette torche qui sert de point de référence de cette torche 1. Ce point donné peut constituer l'origine du repère X, Y, Z.

Selon un autre exemple, dans lequel les moyens de déplacement comportent toujours des premier, second et troisième axes motorisés, la torche peut être uniquement portée par le premier axe motorisé pour déplacer la torche selon l'axe Z qui est toujours perpendiculaire au plan de référence de la carte. Les second et troisième axes motorisés sont reliés aux moyens de support 3a, 3b de la carte. Le second axe motorisé déplace la carte par rapport à la torche suivant un axe parallèle au plan de référence Ref. Le troisième axe motorisé déplace la carte par rapport à la torche suivant un autre axe parallèle au plan de référence Ref. Ces second et troisième axes motorisés forment ici une table de déplacement de la carte suivant un plan parallèle au plan de référence Ref. Les moyens de déplacement utilisés pour mettre en oeuvre l'invention pourraient comporter au moins un robot comportant au moins trois axes ou plusieurs robots en parallèle.

Le dispositif 0 comporte aussi des capteurs pour capter une position relatives du point donné P de la torche 1 par rapport à la carte électronique 4 et en particulier la position relative de ce point donné de la torche par rapport au plan de référence Ref de la carte 4. Ces capteurs non représentés peuvent être intégrés aux axes motorisés.

Lesdits capteurs sont reliés au calculateur 7 du dispositif 0 pour permettre de calculer, à l'aide d'informations provenant desdits capteurs, la position relative de la torche par rapport à la carte.

Le calculateur 7 est aussi adapté à exécuter un algorithme qui est stocké dans des moyens de mémorisation 8 eux même reliés audit calculateur 7.

Des premières données représentatives de la position d'au moins une zone à traiter de la carte électronique, et de positions respectives de surfaces à traiter formées sur certains au moins des composants électroniques et contenues dans cette zone à traiter sont stockées dans ces moyens de mémorisation 8.

Il est à noter que ces premières données représentatives de la position de ladite au moins une zone à traiter de la carte électronique et des positions respectives des surfaces à traiter peuvent être obtenues à partir d'un relevé topographique de la carte et/ou à partir d'un fichier de représentation de la carte dans l'espace.

Comme on le voit sur les figures 2a à 2d, on réalise un relevé topographique de la carte à l'aide de moyens optiques d'observation 9 de la carte 4. En l'occurrence un des moyens optiques peut être :
- un télémètre tel qu'un télémètre laser et/ou
- une caméra et/ou
- plusieurs caméras agencées pour obtenir une représentation en trois dimensions de tout ou partie de la carte où sont localisables la zone à traiter Zn et les surfaces à traiter ainsi que le plan de référence de la carte.

Dans un mode de réalisation, une interface homme machine reliée au calculateur affiche à l'opérateur une représentation de la carte pouvant comporter une photographie de la carte et une représentation du relevé topographique de la carte. L'opérateur peut ainsi, à l'aide de l'affichage, reconnaitre et localiser des surfaces à traiter de la carte et éventuellement redéfinir la zone où se trouvent les surfaces à traiter. Idéalement, sur cette représentation de la carte sont superposées une photographie de la carte obtenue via une caméra et une représentation du relevé topographique de la carte illustrant des hauteurs de points de la carte relevés par exemple à l'aide du télémètre laser.

Alternativement ou en complément du précédent mode où une représentation de la carte est affichée, à partir du relevé topographique de la carte, un algorithme de reconnaissance automatique de formes peut être exécuté par le calculateur pour reconnaitre et localiser automatiquement des surfaces à traiter de la carte. Dans un mode particulier, la surface reconnue et localisée automatiquement par le calculateur peut être affichée via l'interface homme machine pour proposer à l'opérateur de soit valider les surfaces à traiter reconnues et localisées par le calculateur soit modifier manuellement ces surfaces à traiter via l'interface homme machine.

Il est à noter que le relevé topographique peut être constitué d'une matrice de points en trois dimensions.

Des secondes données représentatives de la position relative d'une plage de travail Pt idéale propre à cette torche à plasma par rapport au point donné P de cette torche 1 sont également stockées dans ces moyens de mémorisation 8.

Il est à noter que ces secondes données représentatives de la position relative de la plage de travail Pt idéale peuvent être déduites à l'aide d'une base de donnée indiquant la position de la plage de travail idéale Pt par rapport au point donné de la torche en fonction de mesures de paramètres représentatifs du fonctionnement de la torche tels que la vitesse du flux d'air en sortie de torche et/ou la fréquence et la puissance d'alimentation électrique délivrée aux électrodes de la torche.

En outre réponse à l'exécution de l'algorithme par le calculateur, le calculateur :
- détermine des strates S1, S2, S3 qui sont parallèles audit plan de référence Ref de la carte, chaque surface à traiter étant contenue dans une de ces strates qui lui correspond ; puis
- il génère une trajectoire de déplacement de ladite torche qu'il met en oeuvre à l'aide des moyens de déplacement 5.

Cette trajectoire de déplacement est telle que :
- les surfaces à traiter sont respectivement traitées par projection du flux plasma en suivant un ordre chronologique, consistant à traiter toutes les surfaces à traiter contenues dans une strate donnée avant de commencer à traiter les surfaces à traiter contenues dans une autre des strates données ; et que
- pour chaque strate donnée S1, S2, S3, on traite les surfaces à traiter contenues dans cette strate donnée en déplaçant la torche de manière que ledit point donné P de cette torche 1 suive exclusivement une trajectoire planaire parallèle au plan de référence Ref de la carte électronique 4; et que
- à tout moment donné lors de la projection du flux plasma 2 sur une des surfaces à traiter, on ait une partie courante de surface à traiter recevant ce flux plasma 2 à ce moment donné qui est exclusivement placée dans la plage de travail idéale prédéterminée Pt.

Comme on le voit sur les figures 2a à 2d, la carte 4 comporte plusieurs composants électroniques présentant chacun au moins une surface à traiter ces surfaces à traiter de la carte sont disposés à différentes hauteurs par rapport à un plan de référence Ref.

La zone à traiter Zn de la carte électronique s'étend ici sur toute la carte 4.

Les surfaces à traiter qui appartiennent à la zone à traiter sont réparties en trois strates S1, S2, S3 parallèles entre elles et au plan de référence Ref de la carte.

La première strate S1 s'étend de 0 à 8 mm au-dessus du plan de référence et contient des surfaces à traiter formées sur les composants C1a, C1b, C1c de hauteurs respectives 0 mm, 3 mm, 5 mm et 3 mm.

La deuxième strate S2 s'étend de 12 à 20 mm au-dessus du plan de référence Ref et contient des surfaces à traiter formées sur les composants C2a et C2b de hauteurs respectives 12 mm et 20 mm.

La troisième strate S3 s'étend de 20 à 28 mm au-dessus du plan de référence Ref et contient des surfaces à traiter formées sur le composant C3a qui a une hauteur de 27 mm.

Il est à noter que des strates adjacentes entre elles peuvent se toucher ou être éloignées l'une de l'autre s'il n'y a pas de surface à traiter entre ces strates adjacentes.

Ici la plage idéale de travail Pt de la torche présente une épaisseur de 8 à 10 mm. Cette épaisseur est indiquée sur la figure 2a par la distance Dt est définie entre un premier plan situé à une distance Dmin du point donné P de la torche 1 et un second plan situé à une distance Dmax de ce point donné P. Ces premier et deuxièmes plans sont parallèles au plan de référence Ref.

La torche 1 se déplace verticalement par rapport au plan de référence Ref (déplacement selon l'axe Z parallèle à l'axe de travail 6) pour couvrir successivement les surfaces de la strate S1, puis les surfaces de la strate S2, puis les surfaces de la strate S3 en faisant en sorte que toute surface traitée à un instant donné se trouve placée dans la plage de travail Pt de la torche.

Lorsque la trajectoire de déplacement calculée est exécutée :
- les surfaces à traiter sont traitées strate après strate ; et
- toutes les surfaces contenue dans une même strate sont traitées en ne déplaçant la torche que selon une trajectoire planaire parallèle au plan de référence de la carte électronique, c'est-à-dire sans écarter ni rapprocher la torche vis-à-vis du plan de référence Ref.

La figure 1 illustre les étapes successivement mise en oeuvre lors de l'exécution du procédé selon l'invention par le dispositif 0.

Comme indiqué précédemment, la première étape consiste à réaliser un relevé topographique de la carte et plus particulièrement de la zone à traiter.

La seconde étape consiste à définir la finesse de traitement, c'est-à-dire la plage de travail optimale Pt de la torche. Plus cette plage Pt sera petite et plus on aura une finesse de traitement importante.

L'étape suivante consiste à calculer la trajectoire de déplacement de la torche en exécutant l'algorithme. Au cours de cette deuxième étape, l'algorithme détermine d'abord les positions et épaisseurs des strates par rapport au plan Ref. Ces strates sont déterminées d'une part, en fonction de la finesse de traitement souhaitée, c'est-à-dire en fonction de la valeur Dt déterminant l'étendue et de la position de la plage de traitement optimale Pt, et d'autre part en fonction des positions des surfaces à traiter (ces surfaces à traiter ont été identifiées via le relevé topographique de la zone à traiter) .

Cette trajectoire de déplacement est composée d'une seule trajectoire planaire par strate à couvrir et de plusieurs trajectoires de liaison.

Ainsi, certaines au moins des trajectoires planaires de la trajectoire de déplacement sont reliées entre elles par des trajectoires de liaison, chaque trajectoire de liaison comportant au moins une portion de trajectoire de liaison s'étendant suivant une direction perpendiculaire audit plan de référence Ref (parallèle à l'axe de travail 6).

Le fait, lors du changement de strate, de déplacer le point donné P de référence de la torche perpendiculairement au plan de référence Ref, permet de dégager rapidement la surface traitée de la plage de travail idéale Pt où le flux plasma 2 est le plus puissant.

L'ordre d'exécution des trajectoires planaires peut être déterminé :
- soit de manière à privilégier l'optimisation de la vitesse d'exécution de la trajectoire de déplacement dans son ensemble plutôt que la finesse du traitement ;
- soit de manière à privilégier l'optimisation de la finesse du traitement plutôt que la vitesse d'exécution de la trajectoire de déplacement dans son ensemble.

L'interface homme machine peut être agencée pour permettre à l'opérateur de sélectionner soit l'optimisation de la vitesse d'exécution de la trajectoire de déplacement dans son ensemble soit l'optimisation de la finesse de traitement.

La trajectoire de déplacement est alors calculée en fonction du choix réalisé par l'opérateur.

Dans l'exemple des figures 2a à 2d, on a trois trajectoires planaires à définir, une pour chaque strate S1, S2, S3, chaque trajectoire planaire étant déterminée en fonction de paramètres de recouvrement de passes adjacentes, de vitesse cible de déplacement de la torche, d'accélération cible de déplacement de la torche et en fonction d'une distance latérale minimale souhaitée entre le flux plasma projeté et des composants de la carte électronique. Ici, un admet que sur toute la plage de travail Pt, le flux 2 est de forme cylindrique droite dont le diamètre est compris entre 10 mm et 13 mm et préférentiellement entre 11 et 12 mm.

Le pas de recouvrement qui est largeur de la surface couverte par deux passes adjacentes est compris entre 90 et 100% du diamètre de flux à la distance Dmax. Ici, on choisit typiquement un pas de recouvrement de 10 mm.

Chaque trajectoire de déplacement planaire est aussi déterminée de manière à optimiser le temps du traitement des surfaces à traiter de chaque strate. Il est aussi possible que l'un au moins des point de départ ou point de fin d'une trajectoire planaire donnée soit (soient) imposé(s) afin d'imposer une trajectoire liaison pour l'engagement et/ou une trajectoire de liaison pour le dégagement de la torche vis-à-vis de la strate traitée.

Entre deux trajectoires planaires immédiatement successives est placée une trajectoire de liaison partant d'un point de dégagement de la première de ces trajectoires planaires vers un point d'engagement de la seconde de ces trajectoires planaires.

Chacune des trajectoires planaires et chaque trajectoire de liaison est calculée en prenant en compte des accélérations cibles en début et fin de trajectoire (ici, les accélérations cibles selon les axes X et Y sont de 12.5 m/s² et de 4.5 m/s² selon l'axe Z) et en prenant en compte des masses et inerties de la torche et des axes motorisés (ici la masse de la torche est inférieure à 650 grammes) .

Ici, la plage de travail idéale prédéterminée ainsi que des caractéristiques du flux plasma 2 et des caractéristiques de chacune des trajectoires planaires utilisées pour traiter les surfaces à traiter contenues dans les strates déterminées sont sélectionnées de manière à obtenir une tension de surface d'au moins 46 mN/m après traitement desdites surfaces à traiter de la carte électronique.

Il va maintenant être expliqué une méthode utilisée pour déterminer la plage de travail idéale de la torche à plasma.

Cette plage de travail idéale est prédéterminée / déduite en réalisant :
a) une série d'essais successifs consistant pour chaque essai, à projeter un flux de plasma sur au moins une éprouvette composée au moins partiellement avec un matériau à traiter tel qu'un matériau polymère et au cours de cette série d'essais, on fait varier au moins l'un des paramètres d'essais choisi parmi une liste de paramètres d'essais comprenant :
   - la vitesse de déplacement de la torche par rapport à l'éprouvette ;
   - la distance d'éloignement entre un point de référence de la torche utilisée pour l'essai et une surface d'éprouvette traitée avec cette torche utilisée pour l'essai ;
   - une vitesse de projection de flux de plasma ;
   - une section projection de flux de plasma ;
   - un pas de recouvrement entre deux passes adjacentes de projection de ce flux de plasma ;
   - une fréquence d'alimentation électrique entre des électrodes de la torche ;
   - une puissance d'alimentation électrique entre des électrodes de la torche ;
   - une valeur représentative d'une qualité d'air admis par la torche pour générer le flux de plasma ; puis après réalisation de cette série d'essais
b) on réalise une série de mesures pour mesurer des valeurs représentatives de tensions de surface associées à des surfaces traitées des éprouvettes traitées au cours de la série d'essais ; puis après réalisation de cette série de mesures ;
c) on mémorise au moins un jeu de valeurs optimales des paramètres d'essais que l'on considère adapté pour obtenir une tension de surface minimale souhaitée de surface traitée, chaque au moins un jeu de valeurs optimales des paramètres d'essais contenant au moins une valeur optimale de distance d'éloignement entre un point de référence de la torche d'essai et une surface traitée avec cette torche d'essai, certains au moins desdits au moins un jeu de valeurs optimales de paramètres d'essais étant utilisés pour définir ladite au moins une plage de travail idéale prédéterminée.

En d'autres termes, on fait varier pendant la pluralité des essais, des paramètres de projection de flux de plasma qui influencent les tensions de surface des surfaces des éprouvettes ainsi traitées. Puis on mesure sur les surfaces ainsi traitées les tensions de surface et on sélectionne un ou plusieurs jeux de valeurs optimales qui permettent d'obtenir un niveau minimum de tension de surface souhaités. Comme chaque jeu de paramètre contient au moins une valeur optimale de distance d'éloignement, à l'aide d'une ou plusieurs de ces valeurs optimales de surface d'éloignement, on peut déduire la plage de travail idéale de la torche lorsque celle-ci est utilisée pour traiter une surface donnée dans des conditions de fonctionnement données.

Typiquement, tout essai qui permet d'obtenir un niveau minimum de tension de surface souhaité est associé à un jeu de paramètres d'essais choisis pour réaliser cet essai qui comprend au moins une valeur optimale de distance d'éloignement entre un point de référence de la torche d'essai et une surface traitée avec cette torche d'essai lors de cet essai.

On sait par conséquent que la plage de travail optimale pour cette torche d'essai (qui permet, par exemple, un traitement satisfaisant du matériau polymère ainsi traité) contient au moins la valeur optimale de distance d'éloignement entre un point de référence P de la torche d'essai et la surface traitée avec cette torche d'essai lors de cet essai.

Selon une première approche simplifiée, on peut considérer que la plage de travail optimale pour cette torche est une zone de travail s'étendant entre des premier et second plans perpendiculaires à un axe de travail de cette torche passant par ledit point donné de cette torche. Le premier de ces plans est situé une distance dudit point donné de la torche qui est égale à ladite valeur optimale de distance d'éloignement à laquelle est ajoutée une première valeur de tolérance prédéterminée.

Le second de ces plans est situé une distance dudit point donné P de la torche qui est égale à ladite valeur optimale de distance d'éloignement de laquelle est déduite d'une seconde valeur de tolérance prédéterminée.

Selon une seconde approche, les premier et second plans qui délimitent la plage de travail optimale sont définis en déplaçant la torche tout en faisant varier de manière uniforme la distance d'éloignement entre un point de référence de la torche utilisée pour l'essai et la surface d'éprouvette traitée avec cette torche.

La distance d'éloignement du premier plan délimitant la plage de travail optimale est celle mesurée au moment de l'essai où, pour la première fois, on constate que la qualité de traitement est satisfaisante (c'est-à-dire que la tension de surface est au moins égale à un seuil à atteindre).

La distance d'éloignement du second plan délimitant la plage de travail optimale Pt est celle mesurée au moment de l'essai où, pour la dernière fois, on constate que la qualité de traitement est satisfaisante.

Typiquement, on considère que la plage de travail est délimitée extérieurement par une surface cylindrique ou légèrement conique dont l'axe de travail 6 de la torche 1 constitue un axe directeur, le rayon de cette surface cylindrique étant prédéterminé.

Ce rayon peut par exemple être déterminé lors de la série d'essais et dans ce cas, il peut constituer un des paramètres du jeu de paramètres.

Grâce à l'invention, on peut traiter la carte électronique pour en augmenter la tension de surface tout en limitant considérablement les risques de dégrader la carte pendant ce traitement.

## Revendications

1. Procédé de traitement de surfaces d'une carte électronique (4) à l'aide d'une torche à plasma (1) générant un flux de plasma (2), cette carte (4) comportant plusieurs composants électroniques (C1a, C1b, C1c, C2a, C2b, C3a), la carte (4) présentant plusieurs surfaces à traiter disposées à différentes hauteurs par rapport à un plan de référence (Ref) de la carte électronique (4), certaines au moins de ces surfaces à traiter étant formées sur certains au moins des composants de la carte électronique, **caractérisé en ce que** :
- on détermine au moins une zone à traiter (Zn) de la carte électronique (4), cette zone à traiter (Zn) contenant les surfaces à traiter;
- on détermine une plage de travail idéale (Pt) propre à la torche à plasma (1), cette plage de travail (1) étant localisée par rapport à un point donné (P) de cette torche (1); et
- à l'aide d'un algorithme exécuté par un calculateur (7), on détermine des strates (S1, S2, S3) parallèles audit plan de référence (Ref) de la carte, chacune de ces strates (S1, S2, S3) contenant au moins une des surfaces à traiter qui lui correspond, puis on génère une trajectoire de déplacement de ladite torche telle que lorsque cette trajectoire de déplacement est exécutée :
- les surfaces à traiter soient traitées en suivant un ordre chronologique, consistant à traiter toutes les surfaces à traiter contenues dans une strate donnée avant de commencer à traiter les surfaces à traiter contenues dans une autre des strates données ; et telle que
- pour chaque strate donnée, on traite les surfaces à traiter contenues dans cette strate donnée en déplaçant la torche de manière que ledit point donné (P) de cette torche (1) suive exclusivement une trajectoire planaire parallèle au plan de référence (Ref) de la carte électronique ; et telle que
- à tout moment donné lors de la projection du flux plasma (2) sur une des surfaces à traiter, on ait une partie courante de surface à traiter recevant ce flux plasma à ce moment donné qui est exclusivement placée dans la plage de travail idéale (Pt) prédéterminée.

2. Procédé de traitement de surfaces selon la revendication 1, dans lequel la plage de travail (Pt) présente une limite maximale de travail située à une distance maximale (Dmax) prédéterminée par rapport au point donné de cette torche et une limite minimale de travail située à une distance minimale (Dmin) prédéterminée par rapport audit point donné (P) de cette torche, ces distances minimale et maximale prédéterminées étant mesurées suivant un axe de travail (6) de la torche passant par ledit point donné de cette torche.

3. Procédé selon l'une quelconque des revendications précédentes, dans lequel certaines au moins des trajectoires planaires de la trajectoire de déplacement sont reliées entre elles par des trajectoires de liaison, chaque trajectoire de liaison comportant au moins une portion de trajectoire de liaison s'étendant suivant une direction perpendiculaire audit plan de référence.

4. Procédé selon l'une quelconque des revendications précédentes dans lequel la plage de travail idéale prédéterminée ainsi que des caractéristiques du flux plasma et des caractéristiques de chacune des trajectoires planaires utilisées pour traiter les surfaces à traiter contenues dans les strates déterminées sont sélectionnées de manière à obtenir une tension de surface d'au moins 46 mN/m après traitement desdites surfaces à traiter de la carte électronique.

5. Procédé selon l'une quelconque des revendications précédentes, dans lequel la plage de travail idéale prédéterminée est déduite en réalisant :
a) une série d'essais successifs consistant pour chaque essai, à projeter un flux de plasma sur au moins une éprouvette composée au moins partiellement avec un matériau à traiter et au cours de cette série d'essais, on fait varier au moins l'un des paramètres d'essais choisi parmi une liste de paramètres d'essais comprenant :
- la vitesse de déplacement de la torche par rapport à l'éprouvette ;
- la distance d'éloignement entre un point de référence de la torche utilisée pour l'essai et une surface d'éprouvette traitée avec cette torche utilisée pour l'essai ;
- une vitesse de projection de flux de plasma ;
- une section projection de flux de plasma ;
- un pas de recouvrement entre deux passes adjacentes de projection de ce flux de plasma ;
- une fréquence d'alimentation électrique entre des électrodes de la torche ;
- une puissance d'alimentation électrique entre des électrodes de la torche ;
- une valeur représentative d'une qualité d'air admis par la torche pour générer le flux de plasma ; puis après réalisation de cette série d'essais
b) on réalise une série de mesures pour mesurer des valeurs représentatives de tensions de surface associées à des surfaces traitées des éprouvettes traitées au cours de la série d'essais ; puis après réalisation de cette série de mesures ;
c) on mémorise au moins un jeu de valeurs optimales des paramètres d'essais que l'on considère adapté pour obtenir une tension de surface minimale souhaitée de surface traitée, chaque au moins un jeu de valeurs optimales des paramètres d'essais contenant au moins une valeur optimale de distance d'éloignement entre un point de référence de la torche d'essai et une surface traitée avec cette torche d'essai, certains au moins desdits au moins un jeu de valeurs optimales de paramètres d'essais étant utilisés pour définir ladite au moins une plage de travail idéale prédéterminée.

6. Dispositif de traitement de surfaces (0) d'une carte électronique (4), comportant :
- des moyens de support (3a, 3b) adaptés à supporter une carte électronique (4) comportant plusieurs composants électroniques (C1a, C1b, C1c, C2a, C2b, C3a) disposés à différentes hauteurs par rapport à un plan de référence (Ref) de la carte électronique (4);
- une torche à plasma (1) générant un flux de plasma (2);
- des moyens de déplacement (5) relatif de la torche vis-à-vis des moyens de support (3a, 3b) portant une carte électronique (6) ;
- des moyens de mémorisation (8) dans lesquels sont stockés :
1) des premières données représentatives de la position d'au moins une zone à traiter (Zn) de la carte électronique, et de positions respectives de surfaces à traiter formées sur certains au moins des composants électroniques et contenues dans cette zone à traiter (Zn) ;
2) des secondes données représentatives de la position par rapport à un point donné (P) de cette torche (1) d'une plage de travail idéale (Pt) propre à cette torche à plasma (1) ; et
3) un algorithme ;
ce dispositif de traitement de surface (0) comportant en outre un calculateur (7) adapté à exécuter ledit algorithme et, en réponse à l'exécution de cet algorithme, à :
- déterminer des strates (S1, S2, S3) parallèles audit plan de référence (Ref) de la carte, chaque surface à traiter étant contenue dans une de ces strates qui lui correspond ; puis
- à générer une trajectoire de déplacement de ladite torche (1) mise en oeuvre à l'aide des moyens de déplacement (5) et telle que :
- les surfaces à traiter soient respectivement traitées par projection du flux plasma (2) en suivant un ordre chronologique, consistant à traiter toutes les surfaces à traiter contenues dans une strate donnée avant de commencer à traiter les surfaces à traiter contenues dans une autre des strates données ; et telle que
- pour chaque strate donnée (S1, S2, S3), on traite les surfaces à traiter contenues dans cette strate donnée en déplaçant la torche (1) de manière que ledit point donné (P) de cette torche suive exclusivement une trajectoire planaire parallèle au plan de référence (Ref) de la carte électronique ; et telle que
- à tout moment donné lors de la projection du flux plasma (2) sur une des surfaces à traiter, on ait une partie courante de surface à traiter recevant ce flux plasma à ce moment donné qui est exclusivement placée dans la plage de travail idéale (Pt) prédéterminée.

## Patentansprüche

1. Verfahren zum Behandeln von Oberflächen einer Leiterkarte (4) mit Hilfe eines Plasmabrenners (1), der einen Plasmafluss (2) erzeugt, wobei diese Karte (4) mehrere elektronische Bauelemente (C1a, C1b, C1c, C2a, C2b, C3a) umfasst, wobei die Karte (4) mehrere zu behandelnde Oberflächen aufweist, die in Bezug auf eine Referenzebene (Ref) der Leiterkarte (4) in unterschiedlichen Höhen angeordnet sind, wobei zumindest einige dieser zu behandelnden Oberflächen auf zumindest einigen der Bauelemente der Leiterkarte ausgebildet sind, **dadurch gekennzeichnet, dass**
- man mindestens eine zu behandelnde Zone (Zn) der Leiterkarte (4) bestimmt, wobei diese zu behandelnde Zone (Zn) die zu behandelnden Oberflächen enthält;
- man einen für den Plasmabrenner (1) spezifischen idealen Arbeitsbereich (Pt) bestimmt, wobei dieser Arbeitsbereich (1) in Bezug auf einen gegebenen Punkt (P) dieses Brenners (1) lokalisiert ist; und
- man mit Hilfe eines von einem Rechner (7) ausgeführten Algorithmus Schichten (S1, S2, S3) bestimmt, die parallel zu der genannten Referenzebene (Ref) der Karte sind, wobei jede dieser Schichten (S1, S2, S3) mindestens eine der zu behandelnden Oberflächen enthält, die ihr entspricht, und man dann eine Bewegungsbahn für den genannten Brenner erzeugt, so dass, wenn diese Bewegungsbahn ausgeführt wird:
- die zu behandelnden Oberflächen in chronologischer Reihenfolge behandelt werden, bestehend aus dem Behandeln aller zu behandelnden Oberflächen, die in einer gegebenen Schicht enthalten sind, ehe man beginnt, die zu behandelnden Oberflächen zu behandeln, die in einer anderen der gegebenen Schichten enthalten sind; und so, dass
- man für jede gegebene Schicht die zu behandelnden Oberflächen, die in dieser gegebenen Schicht enthalten sind, behandelt, indem man den Brenner derart bewegt, dass der genannte gegebene Punkt (P) dieses Brenners (1) ausschließlich einer planaren Bahn folgt, die parallel zu der Referenzebene (Ref) der Leiterkarte ist; und so, dass
- man zu jedem gegebenen Zeitpunkt während der Projektion des Plasmaflusses (2) auf eine der zu behandelnden Oberflächen einen aktuellen Teil der zu behandelnden Oberfläche hat, der diesen Plasmafluss zu diesem gegebenen Zeitpunkt empfängt und der ausschließlich in dem vorbestimmten idealen Arbeitsbereich (Pt) platziert ist.

2. Verfahren zum Behandeln von Oberflächen nach Anspruch 1, bei dem der Arbeitsbereich (Pt) eine maximale Arbeitsgrenze aufweist, die sich in einem vorbestimmten maximalen Abstand (Dmax) in Bezug auf den gegebenen Punkt dieses Brenners befindet, sowie eine minimale Arbeitsgrenze, die sich in einem vorbestimmten minimalen Abstand (Dmin) in Bezug auf den gegebenen Punkt (P) dieses Brenners befindet, wobei der vorgegebene minimale Abstand und der vorgegebene maximale Abstand entlang einer Arbeitsachse (6) des Brenners gemessen werden, die durch den genannten gegebenen Punkt dieses Brenners hindurchgeht.

3. Verfahren nach einem der vorhergehenden Ansprüche, bei dem zumindest einige der planaren Bahnen der Bewegungsbahn miteinander über Verbindungsbahnen verbunden sind, wobei jede Verbindungsbahn mindestens einen Verbindungsbahnabschnitt umfasst, der sich in einer Richtung senkrecht zur genannten Referenzebene erstreckt.

4. Verfahren nach einem der vorhergehenden Ansprüche, bei dem der vorbestimmte ideale Arbeitsbereich sowie Merkmale des Plasmaflusses und Merkmale jeder der planaren Bahnen, die zum Behandeln der zu behandelnden Oberflächen verwendet werden, die in den bestimmten Schichten enthalten sind, derart ausgewählt werden, dass man eine Oberflächenspannung von mindestens 46 mN/m nach Behandlung der genannten zu behandelnden Oberflächen der Leiterkarte erhält.

5. Verfahren nach einem der vorhergehenden Ansprüche, bei dem der vorbestimmte ideale Arbeitsbereich hergeleitet wird, indem man durchführt:
a) eine Reihe von aufeinanderfolgenden Versuchen, die für jeden Versuch darin besteht, einen Plasmafluss auf mindestens eine Probe zu projizieren, die zumindest teilweise aus einem zu behandelnden Material besteht, und man während dieser Versuchsreihe mindestens einen der Versuchsparameter ändert, der aus einer Liste von Versuchsparametern ausgewählt wird, die umfasst:
- die Bewegungsgeschwindigkeit des Brenners in Bezug auf die Probe;
- den Entfernungsabstand zwischen einem Referenzpunkt des Brenners, der für den Versuch verwendet wird, und einer Probenoberfläche, die mit diesem für den Versuch verwendeten Brenner behandelt wird;
- eine Projektionsgeschwindigkeit des Plasmaflusses;
- einen Projektionsquerschnitt des Plasmaflusses;
- einen Schritt der Überlappung zwischen zwei angrenzenden Durchläufen zur Projektion diese Plasmaflusses;
- eine Frequenz einer elektrischen Versorgung zwischen Elektroden des Brenners;
- eine Leistung der elektrischen Versorgung zwischen Elektroden des Brenners;
- einen Wert, der repräsentativ für eine Luftqualität ist, die von dem Brenner zugeführt wird, um den Plasmafluss zu erzeugen; und dann nach Ausführung dieser Versuchsreihe
b) eine Reihe von Messungen durchgeführt wird, um Werte zu messen, die repräsentativ für Oberflächenspannungen sind, die mit den behandelten Oberflächen der Proben in Verbindung stehen, die während der Versuchsreihe behandelt wurden; und dann nach Ausführung dieser Reihe von Messungen;
c) man mindestens einen Satz von optimalen Versuchsparameterwerten speichert, die man für geeignet hält, um eine gewünschte minimale Oberflächenspannung der behandelten Oberfläche zu erhalten, wobei jeder mindestens eine Satz von optimalen Versuchsparameterwerten mindestens einen optimalen Wert für einen Entfernungsabstand zwischen einem Referenzpunkt des Versuchsbrenners und einer mit diesem Versuchsbrenner behandelten Oberfläche enthält, wobei zumindest einige des genannten mindestens einen Satzes von optimalen Versuchsparameterwerten verwendet werden, um den genannten mindestens einen vorbestimmten idealen Arbeitsbereich zu definieren.

6. Vorrichtung zur Behandlung von Oberflächen (0) einer Leiterkarte (4), umfassend:
- Trägermittel (3a, 3b), die dazu geeignet sind, eine Leiterkarte (4) zu tragen, die mehrere elektronische Bauelemente (C1a, C1b, C1c, C2a, C2b, C3a) umfasst, die in Bezug auf eine Referenzebene (Ref) der Leiterkarte (4) in unterschiedlichen Höhen angeordnet sind;
- einen Plasmabrenner (1), der einen Plasmafluss (2) erzeugt;
- Bewegungsmittel (5) zur Relativbewegung des Brenners gegenüber den Trägermitteln (3a, 3b), die eine Leiterkarte (6) tragen;
- Speichermittel (8), in denen gespeichert sind:
1) erste Daten, die repräsentativ für die Position mindestens einer zu behandelnden Zone (Zn) der Leiterkarte und für entsprechende Positionen der zu behandelnden Oberflächen sind, die zumindest auf einigen der elektronischen Bauelemente ausgebildet und in dieser zu behandelnden Zone (Zn) enthalten sind;
2) zweiten Daten, die repräsentativ für die Position eines für diesen Plasmabrenner (1) spezifischen idealen Arbeitsbereichs (Pt) in Bezug auf einen gegebenen Punkt (P) dieses Brenners (1) sind; und
3) ein Algorithmus;
wobei diese Oberflächenbehandlungsvorrichtung (0) ferner einen Rechner (7) umfasst, der dazu geeignet ist, den genannten Algorithmus auszuführen, und in Antwort auf die Ausführung dieses Algorithmus:
- Schichten (S1, S2, S3) zu bestimmen, die parallel zur genannten Referenzebene (Ref) der Karte sind, wobei jede zu behandelnde Oberfläche in einer dieser Schichten, die ihr entspricht, enthalten ist; und dann
- eine Bewegungsbahn des genannten Brenners (1) zu erzeugen, die mit Hilfe der Bewegungsmittel (5) umgesetzt wird, und derart, dass:
- die zu behandelnden Oberflächen jeweils durch Projektion des Plasmaflusses (2) in einer chronologischen Reihenfolge behandelt werden, bestehend aus dem Behandeln aller zu behandelnden Oberflächen, die in einer gegebenen Schicht enthalten sind, ehe die zu behandelnden Oberflächen, die in einer anderen der gegebenen Schichten enthalten sind, zu behandeln begonnen werden; und derart, dass
- man für jede gegebene Schicht (S1, S2, S3) die zu behandelnden Oberflächen, die in dieser gegebenen Schicht enthalten sind, behandelt, indem man den Brenner (1) derart bewegt, dass der gennannte gegebene Punkt (P) dieses Brenners ausschließlich einer planaren Bahn folgt, die parallel zur Referenzebene (Ref) der Leiterkarte ist; und derart, dass
- man zu jedem gegebenen Zeitpunkt während der Projektion des Plasmaflusses (2) auf eine der zu behandelnden Oberflächen einen aktuellen Abschnitt der zu behandelnden Oberfläche hat, der diesen Plasmafluss zu diesem gegebenen Zeitpunkt empfängt und der ausschließlich in dem vorbestimmten idealen Arbeitsbereich (Pt) liegt.

## Claims

1. A method for treating surfaces of an electronic card (4) using a plasma torch (1) generating a stream (2) of plasma, this card (4) including multiple electronic components (C1a, C1b, C1c, C2a, C2b, C3a), the card (4) having multiple surfaces to be treated that are positioned at various heights with respect to a reference plane (Ref) of the electronic card (4), at least some of these surfaces to be treated being formed on at least some of the components of the electronic card, **characterized in that**:
- at least one zone (Zn) to be treated of the electronic card (4) is determined, this zone (Zn) to be treated containing the surfaces to be treated;
- an ideal working range (Pt) specific to the plasma torch (1) is determined, this working range (1) being localized with respect to a given point (P) of this torch (1); and
- using an algorithm run by a computer (7), strata (S1, S2, S3) that are parallel to said reference plane (Ref) of the card are determined, each of these strata (S1, S2, S3) containing at least one of the surfaces to be treated corresponding thereto, then a trajectory for the movement of said torch is generated such that when this movement trajectory is followed:
- the surfaces to be treated are treated in a chronological order, consisting in treating all of the surfaces to be treated contained in a given stratum before starting to treat the surfaces to be treated contained in another of the given strata; and such that
- for each given stratum, the surfaces to be treated contained in this given stratum are treated by moving the torch so that said given point (P) of this torch (1) exclusively follows a planar trajectory that is parallel to the reference plane (Ref) of the electronic card; and such that
- at any given instant in time during the projection of the plasma stream (2) onto one of the surfaces to be treated, there is a current portion of the surface to be treated receiving this plasma stream at this given instant in time that is exclusively placed in the predetermined ideal working range (Pt).

2. The method for treating surfaces as claimed in claim 1, in which the working range (Pt) has a maximum working limit that is located at a predetermined maximum distance (Dmax) with respect to the given point of this torch and a minimum working limit that is located at a predetermined minimum distance (Dmin) with respect to said given point (P) of this torch, these predetermined minimum and maximum distances being measured along a working axis (6) of the torch passing through said given point of this torch.

3. The method as claimed in either of the preceding claims, in which at least some of the planar trajectories of the movement trajectory are linked to one another by linking trajectories, each linking trajectory including at least one linking trajectory portion extending in a direction that is perpendicular to said reference plane.

4. The method as claimed in any one of the preceding claims, in which the predetermined ideal working range, as well as properties of the plasma stream and properties of each of the planar trajectories that are used to treat the surfaces to be treated contained in the determined strata, are selected so as to obtain a surface tension of at least 46 mN/m after treatment of said surfaces to be treated of the electronic card.

5. The method as claimed in any one of the preceding claims, in which the predetermined ideal working range is deduced by carrying out:
a) a series of successive tests consisting, for each test, in projecting a plasma stream onto at least one sample that is at least partially composed of a material to be treated and, during this series of tests, at least one of the test parameters chosen from a list of test parameters is varied, this list comprising:
- the speed of movement of the torch with respect to the sample;
- the distance separating a reference point of the torch used for the test and a sample surface treated with this torch used for the test;
- a speed of projection of the plasma stream;
- a projection cross section of the plasma stream;
- a degree of overlap between two adjacent passes of the projection of this plasma stream;
- a frequency of the electrical power supply between electrodes of the torch;
- a power of the electrical power supply between electrodes of the torch;
- a value that is representative of a quality of the air taken in by the torch in order to generate the plasma stream; then, after carrying out this series of tests
b) a series of measurements are carried out in order to measure values that are representative of surface tensions associated with treated surfaces of the samples treated during the series of tests; then, after carrying out this series of measurements;
c) at least one set of optimum test parameter values that is considered to be suitable for obtaining a desired minimum surface tension of the treated surface is memorized, each at least one set of optimum test parameter values containing at least one optimum value of the distance separating a reference point of the test torch and a surface treated with this test torch, at least some of said at least one set of optimum test parameter values being used to define said at least one predetermined ideal working range.

6. A device (0) for treating surfaces of an electronic card (4), including:
- support means (3a, 3b) that are suitable for supporting an electronic card (4) including multiple electronic components (C1a, C1b, C1c, C2a, C2b, C3a) that are positioned at various heights with respect to a reference plane (Ref) of the electronic card (4);
- a plasma torch (1) generating a plasma stream (2) ;
- means (5) for the relative movement of the torch with respect to the support means (3a, 3b) bearing an electronic card (6);
- memorization means (8) in which the following are stored:
1) first data that are representative of the position of at least one zone (Zn) to be treated of the electronic card, and of respective positions of surfaces to be treated that are formed on at least some of the electronic components and contained within this zone (Zn) to be treated;
2) second data that are representative of the position, with respect to a given point (P) of this torch (1), of an ideal working range (Pt) specific to this plasma torch (1); and
3) an algorithm;
this surface treatment device (0) additionally including a computer (7) that is suitable for running said algorithm and, in response to the running of this algorithm, for:
- determining strata (S1, S2, S3) that are parallel to said reference plane (Ref) of the card, each surface to be treated being contained in one of these strata corresponding thereto; then
- generating a trajectory for the movement of said torch (1) implemented using the movement means (5) and such that:
- the surfaces to be treated are respectively treated by the projection of the plasma stream (2) in a chronological order, consisting in treating all of the surfaces to be treated contained in a given stratum before starting to treat the surfaces to be treated contained in another of the given strata; and such that
- for each given stratum (S1, S2, S3), the surfaces to be treated contained in this given stratum are treated by moving the torch (1) so that said given point (P) of this torch exclusively follows a planar trajectory that is parallel to the reference plane (Ref) of the electronic card; and such that
- at any given instant in time during the projection of the plasma stream (2) onto one of the surfaces to be treated, there is a current portion of the surface to be treated receiving this plasma stream at this given instant in time that is exclusively placed in the predetermined ideal working range (Pt).
